# EUROPEAN PATENT APPLICATION

(11) **EP 1 890 527 A1**
(43) Date of publication of application: **20.02.2008**
(21) Application number: 06732173.7
(22) Date of filing: 14.04.2006
(51) Int. Cl.: H05K 9/00

(54) **ELECTRIC APPARATUS SYSTEM WITH ELECTROMAGNETIC WAVE SUPPRESSING FUNCTION**

(30) Priority: 10.06.2005 JP 2005211876
(71) Applicant: Regina Co., Ltd., Ichikawa-Shi, Chiba, 2720021 (JP)
(72) Inventor: TSUCHIDA, Naoki, c/o REGINA CO., LTD., Ichikawa-Shi, Chiba 2720021 (JP)
(74) Representative: Hooiveld, Arjen Jan Winfried
(86) International application number: PCT/JP2006/308365
(87) International publication number: WO 2006/132038

(57) **Abstract**

Electric equipment comprises an electric appliance and a conductive woven fabric formed by weaving conductive fibers therein. This conductive woven fabric is arranged so as to cover the electric appliance, a ground wire is connected to the conductive woven fabric, and the electric equipment has a single-phase three-wire plug configured so as to combine the ground wire and power wires of the electric appliance.

## Description

### Field of the Invention

The present invention relates to an electric equipment with an electromagnetic wave suppressing function capable of suppressing the generation of an extremely low frequency electromagnetic wave generated from an electric appliance in ordinary home (electromagnetic wave generated from domestic AC power supply).

### Description of the Related Art

Conventionally, no special countermeasures have been taken against an extremely low frequency electromagnetic wave generated from a domestic AC power supply of a domestic electric appliance or the like, and the fact is that a free rein has been given to it. Therefore, in recent years, it has been demanded to suppress adverse influences on mind and body (headache, nausea, irritation and the like) by the extremely low frequency electromagnetic wave generated from the domestic power supply.

The electromagnetic wave is generally a synthesized wave of an electric field and a magnetic field in a form of energy generated by using electricity. The magnetic field is generated by current flowing through an electric appliance. More specifically, in a state where a power supply switch of the electric appliance is turned off, the magnetic field is not generated. In contrast, the electric field is generated only by applying voltage. That is, even in a state where the power supply switch of the electric appliance is turned off, the electric field is generated only by a plug inserted into an outlet.

Accordingly, in order to suppress the generation of the electric field, and suppress the generation of the electromagnetic wave, it is considered to disconnect the plug from the outlet, or to ground.

To ground, which is the latter case, has a problem in that the size of an estate is not sufficient in housing conditions of the day, and further in that because the engineering works for grounding are not as easy as before, the cost is increased, so that the execution is difficult in ordinary home. Therefore, it has been proposed that the electric appliance is covered with a conductor, and the conductor is connected to ground.

Consequently, a conductive woven fabric is formed by weaving the conductor therein, and a domestic electric appliance such as an electric blanket and an electric carpet, for example, is covered with this conductive woven fabric, and use it. That is, it has been proposed that the conductive woven fabric is used as a cover of the electric appliance.

As the conductor which is woven into this conductive woven fabric, a copper wire or the like has been generally used. However, because the conductor of the copper wire or the like is hard, there has been a problem in that the texture is deteriorated particularly in the case where the conductive woven fabric is used as an electric blanket cover, electric carpet cover or the like.

### SUMMARY OF THE INVENTION

The present invention has beenmade under the circumstances as described above, and its object of the present invention is to provide electric equipment with an electromagnetic wave suppressing function in which an electric appliance is grounded easily and securely, and whose texture is favorable.

The above-described object of the present invention is achieved by providing electric equipment with an electromagnetic wave suppressing function comprising an electric appliance, and a conductive woven fabric formed by weaving conductive fibers therein, wherein the conductive woven fabric is arranged so as to cover the electric appliance, a ground wire is connected to the conductive woven fabric, and the electric equipment has a single-phase three-wire plug configured so as to combine the ground wire and power wires of the electric appliance.

Moreover, the above-described object of the present invention is effectively achieved by providing the electric equipment with the electromagnetic wave suppressing function, wherein the ground wire is provided with a clip at one end thereof, and the ground wire is connected to the conductive woven fabric by pinching the conductive woven fabric by the clip.

### THE EFFECT OF THE INVENTION

According to the electric equipment with the electromagnetic wave suppressing function of the present invention, since electric equipment comprises the electric appliance and the conductive woven fabric formed by weaving the conductive fibers therein, the conductive woven fabric is arranged so as to cover the electric appliance, further the ground wire is connected to the conductive woven fabric, further more, the electric equipment has a single-phase three-wire plug composed so as to combine this ground wire and the power wires of the electric appliance, the electric equipment can be grounded easily and securely.

Moreover, since the clip is provided at the one end of the ground wire to be connected to the conductive woven fabric, the ground wire can be easily detached from, or connected to the conductive woven fabric. This allows the ground wire to be detached easily when a user wants to wash the conductive woven fabric, or the like.

### BRIEF DESCRIPTION OF THE DRAWINGS

Fig. 1 is a schematic configuration diagram of electric equipment with an electromagnetic wave suppressing function according to the present invention.
Fig. 2 is a cross-sectional view along I-I in Fig. 1.

### DESCRIPTION OF THE PREFERRED EMBODIMENT

Hereinafter, referring to the drawings, electric equipment with an electromagnetic wave suppressing function according to the present invention is described in detail. The electric equipment with the electromagnetic wave suppressing function according to the present invention is not limited to the following embodiment, it goes without saying that the configuration can be changed as necessary within a purview not departing from the scope of claims.

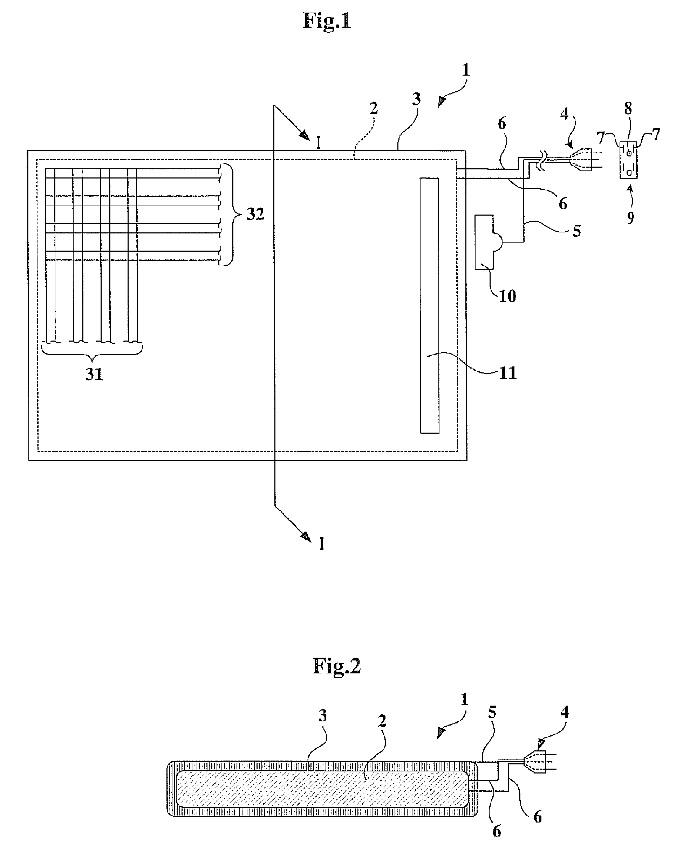

Fig. 1 is a schematic configuration diagram of the electric equipment with the electromagnetic wave suppressing function according to the present invention (hereinafter, abbreviated as "the present electric equipment"). Fig. 2 is a cross-sectional view along I-I in Fig. 1. As shown in the figures, the present electric equipment 1 provides an electric appliance 2 and a conductive woven fabric 3.

The conductive woven fabric 3 is formed by weaving conductive fibers therein. More specifically, the conductive woven fabric 3 is formed by weaving the conductive fibers into both or either of warps 31 and wefts (woofs) 32. In this case, as the conductive fibers, one, or the combination of two or more of various types of metal fibers such as copper fibers, brass fibers, aluminum fibers, stainless fibers, silver wires, gold wires, nickel fibers, and iron fibers, carbon fibers, carbon fibers which metal is vapor-deposited and coated on a surface thereof, and the like, is used.

In this manner, by weaving the conductive fibers to form the conductive woven fabric 3, in the case where the conductive woven fabric 3 is used as an electric carpet cover, electric blanket cover or the like, for example, the electric appliance 2 (that is, the electric carpet or electric blanket) can be grounded although the conductive woven fabric 3 has soft touch, and an electromagnetic wave, particularly an electric field, radiated from the electric appliance 2, can be blocked off.

Moreover, the present electric equipment 1 has a single-phase three-wire plug 4. More specifically, in the present electric equipment 1, a ground wire 5 is connected to the conductive woven fabric 3, and the present electric equipment 1 has the single-phase three-wire plug 4 formed by combining this ground wire 5 and power wires 6, 6 of the electric appliance 2.

As this single-phase three-wire plug 4, as shown in Fig. 1, is used the one which has a shape corresponding to an outlet 9 having insertion holes 7, 7 of a pair of rectangular openings of a single-phase power supply to be connected to the power wires 6, 6 of the electric appliance 2, and an insertion hole 8 of a circular opening to be connected to the ground wire 5. The insertion hole 8 of the circular opening is connected to the ground.

While in use in Japan, the outlet having the shape as shown in Fig. 1, and the plug corresponding to this outlet are used, when applied to an electric appliance used in a country other than Japan, an outlet and a plug having a shape adapted to a power supply of each country are used.

Moreover, in the present electric equipment 1, as shown in Fig. 2, the conductive woven fabric 3 is arranged so as to cover the electric appliance 2.

In this manner, since the present electric equipment 1 is constituted by covering the electric appliance 2 with the conductive woven fabric 3, only inserting the single-phase three-wire plug 4 into the outlet 9 connecting the ground, it allows to be grounded of the electric appliance 2 easily and surely, and the electromagnetic wave radiated from the electric appliance 2 to be blocked off easily.

Moreover, as shown in Fig. 1, the ground wire 5 preferably has a constitution in which a clip 10 is provided at one end thereof to pinch the conductive fibers woven into the conductive woven fabric 3.

Such a constitution makes the connection of the ground wire 5 easy, and as well, makes the detachment of the ground wire 5 easy. Accordingly, the conductive woven fabric 3 can be easily detached from the electric appliance 2 to be washed, and the conductive woven fabric 3 can be easily attached to the electric appliance 2.

In this case, in the conductive woven fabric 3, it is preferable that an electrode 11 to connect the ground wire 5 is provided along one end edge of the conductive woven fabric 3. More specifically, a constitution in which the clip 10 provided at the one end of the ground wire 5 pinches the electrode 11 allows the ground wire 5 to be connected to the conductive woven fabric 3 more easily and securely.

In the case where the conductive woven fabric 3 is formed by weaving the conductive fibers into either of the warps 31 or the wefts 32, the electrode 11 needs to be provided. However, in the case where the conductive woven fabric 3 is formed by weaving the conductive fibers into both of the warps 31 and the wefts 32, the electrode 11 may be made small or may not be provided.

As described above, according to the present electric equipment 1, since the electric appliance 2 can be grounded easily and securely, the electromagnetic wave radiated from the electric appliance 2 to the outside, particularly a leaking electromagnetic wave, extremely low frequency electromagnetic wave, and electric field can be blocked off easily and securely.

## Claims

1. Electric equipment (1) with an electromagnetic wave suppressing function, **characterized by** an electric appliance (2), and a conductive woven fabric (3) formed by weaving conductive fibers therein,
wherein the conductive woven fabric (3) is arranged so as to cover the electric appliance (2), a ground wire (5) is connected to the conductive woven fabric (3), and the electric equipment (1) has a single-phase three-wire plug (4) configured so as to combine the ground wire (5) and power wires (6) of the electric appliance.

2. The electric equipment (1) with the electromagnetic wave suppressing function according to claim 1, wherein the ground wire (5) is provided with a clip (10) at one end thereof, and the ground wire (5) is connected to the conductive woven fabric (3) by pinching the conductive woven fabric (3) by the clip (10).
